# EUROPEAN PATENT SPECIFICATION

(11) **EP 1 518 244 B1**
(45) Date of publication and mention of the grant of the patent: **17.10.2007**
(21) Application number: 03742405.8
(22) Date of filing: 02.07.2003
(51) Int. Cl.: G11C 8/08

(54) **WORDLINE LATCHING IN SEMICONDUCTOR MEMORIES**
VERRIEGELUNG EINER WORTLEITUNG IN EINEM HALBLEITERSPEICHER
VERROUILLAGE PAR LIGNES DE MOT DANS LES MEMOIRES A SEMICONDUCTEUR

(30) Priority: 02.07.2002 US 190372
(43) Date of publication of application: 30.03.2005
(73) Proprietor: ADVANCED MICRO DEVICES, INC., Sunnyvale, California 94088-3453 (US)
(72) Inventor: GIESEKE, Alan, San Jose, CA 95118 (US); MCGEE, William, A., San Jose, CA 95120 (US); MILIC-STRKALJ, Ognjen, San Jose, CA 95128 (US)
(74) Representative: Wright, Hugh Ronald
(86) International application number: PCT/US2003/020872
(87) International publication number: WO 2004/006261

(56) References cited:
- EP-A- 0 533 096
- GB-A- 2 239 541
- US-A- 5 031 141
- US-A- 5 530 677

## Description

### BACKGROUND

### TECHNICAL FIELD

The present invention relates generally to semiconductor memories and more specifically to controlling of wordline signals.

### BACKGROUND ART

Microprocessors are used in many applications including personal computers and other electronic systems. A goal of any microprocessor is to process information quickly. One problem has been the communication rate between a microprocessor and main memory. The instructions to be executed by the microprocessor and the data on which operations implemented by the instructions are to be performed are stored at addresses within main memory. To access instructions and data, the microprocessor transmits addresses to main memory. The main memory decodes the address and makes the contents at the requested address available for reading and/or writing. The time required for the microprocessor to transmit an address to main memory and receive the respective contents therefrom can significantly constrain system performance.

One technique, which is used to increase the speed with which the microprocessor processes information, is to provide the microprocessor with an architecture, which includes a fast local memory called a cache memory

A cache memory is a small, fast memory that keeps copies of recently used data or instructions. When these items are reused, they can be accessed from the cache memory instead of main memory. Instead of operating at slower main memory access speeds, the microprocessor can operate at faster cache memory access speeds most of the time.

In order to further increase performance, microprocessors have come to include more than one cache memory on the same semiconductor substrate as the microprocessor.

The most commonly used cache memories use static random access memory (SRAM) circuitry, which provide high densities using wordlines and bitlines to access SRAM memory cells. However, in order to place as much memory on the microprocessor die as possible, SRAM circuitry requires minimal cell and read/write circuit architectures. To support minimal architectures, a memory cell is accessed by enabling a row wordline wire and enabling a selected column-gating transistor to read the value from the memory cell.

The use of memory circuits in battery-operated and other low-voltage devices make it desirable to operate the memory circuits at lowest voltage possible. Typically, when read or write operations are done in memory arrays, the wordline is set high with the power applied while the information stored in the memory cells is read by being transferred onto bitlines or information on the bitlines is written by being stored in the memory cells. For read operations, bitlines are then read by a sense-amplifier, or sense-amp. Sense-amps are common to all memories whether the memories are dynamic, static, Flash, or other types of memories. For write operations, information on the bitlines change the held charge in the memory cell. While the wordline is kept on, power is being consumed. The wordline remains on during and after the desired operation, whether it is a read or a write, to ensure the operation is complete; i.e., power is consumed even when no longer required.

Reading reliable results from memory circuits operating at a low-power supply voltage is complicated by the large capacitance of the wordlines and the threshold drop produced by the gating transistor. Low-power supply voltages reduce memory speed, and at very low voltages, the reliability of the information drops.

To address the reliability problem, memory circuits, which have a bootstrapped boost voltage applied to the wordlines, have been developed. The row wordline is charged to a voltage that is higher than the power supply line. In addition, the row wordline is charged prior to accessing the memory location by switching on the column-gating transistor. Boost circuits provide reliable memory operation at low voltages.

One of the problems with boost circuits is that at high voltages, the access circuitry is over-stressed. This limits the upper end of the power supply operating range of a memory device.

Another problem is that boosting increases the power consumption of a memory circuit. At high supply voltages, the power dissipation can exceed tolerable levels and the memory circuitry is subject to failures due to overheating.

Power saving has been a persistent need. Because low-power consumption is becoming even more important, it is desirable to provide a method and apparatus for operating a memory device in a manner that saves power. Furthermore, it is desirable to achieve reliable read and write operations at low voltages.

With the urgency of increasing speed and saving power, solutions to these problems have been long sought but have long eluded those skilled in the art.

A reference may be made to EP-A-0 533 096 which discloses an addressing system comprises an address buffer unit (11) responsive to a clock signal (CLK) of a low level for latching an address signal (A0 to Ax) indicative of one of word lines (WL1 to WLm), and maintaining the address signal until the clock signal is shifted to from a high level to the low level again; an address decoder unit (12) coupled with the address buffer unit for selectively driving decoded signal lines (XS1 to XSm); a timing control unit (14) responsive to the clock signal for producing an in-phase timing signal (TM); and a driver unit (13) having a plurality of driver circuits (131 to 13m) respectively coupled between the decoded signal lines and the plurality of word lines, wherein the plurality of driver circuits are operative to respectively latch logic levels on the associated decoded signal lines when the in-phase timing signal is shifted from the low level to the high level so as to selectively drive the word lines to active level, and maintains all of the word lines in inactive level while the in-phase timing signal remains in the low level, thereby preventing the word lines from multiple selection.

Reference may also be made to US-A-5 031 141 which discloses a circuit for generating timing signals for operating an on-chip cache memory in which read operations of the cache memory occur in a first phase of a clock cycle and while operations occur in a second phase of the clock cycle and in which the operations to be accomplished in the second phase require a time for performance which may exceed the length of the second phase comprising means for generating the beginning of a write select signal as soon after the occurrence of both a write pulse and a hit signal as possible, and means for terminating the write select signal after a delay initiated by second phase of the clock cycle and termianted after a time sufficient to allow a write to take plate which time may actually extend into the next phase of the clock cycle.

### DISCLOSURE OF THE INVENTION

The present invention provides a memory system comprising:
memory cells for containing data;
bitlines for writing data in and reading data from the memory cells; wordlines for causing the bitlines to write data in the memory cells in response to wordline signals;
a decoder to receive and decode address information in response to a clock signal and an address signal to select a wordline for a write to a memory cell, wherein the decoder is responsive to the clock signal having rising and falling edges, and the decoder is responsive to the rising edge to start to the decode and the falling edge to stop the decode;
latch circuitry responsive to the clock signal to provide the wordline signal to the selected wordline for the write to the memory cell and to remove the wordline signal from the selected wordline when the write to the memory cell is complete, wherein the latch circuitry is responsive to the falling edge of the clock signal and a write-enable signal to latch the wordline signal on the selected wordline for the write to the memory cell, and the latch circuitry is responsive to a second rising edge of the clock signal to unlatch the wordline signal from the selected wordline.

The memory system conserves power while permitting reliable read and write operations at low voltages.

The invention also provides a method for memory system operation comprising:
providing memory cells for containing data;
writing data in and reading data from the memory cells on bitlines;
responding to wordline signals on wordlines by causing the bitlines to write data in the memory cells;
selecting a wordline for a write to a memory cell using a decoder for receiving and decoding address information in response to a clock signal and an address signal, wherein selecting the wordline includes responding to a rising edge of the clock signal by the decoder to start decoding and a falling edge of the clock signal to stop decoding;
latching a wordline signal in response to the clock signal by providing the wordline signal to the selected wordline for the write to the memory cell and for unlatching the wordline signal from the selected wordline when the write to the memory cell is complete, wherein latching a wordline signal includes:
   responding to the falling edge of the clock signal and a write-enable signal by latching the wordline signal on the selected wordline for writing to the memory cell; and
   responding to a second rising edge of the clock signal by unlatching the wordline signal from the selected wordline.

Certain embodiments of the invention have other advantages in addition to or in place of those mentioned above. The advantages will become apparent to those skilled in the art from a reading of the following detailed description when taken with reference to the accompanying drawings.

### BEST MODE FOR CARRYING OUT THE INVENTION

An SRAM with core regions typically includes one or more M x N arrays of individually addressable, substantially identical memory cells. Peripheral portions typically include input/output (I/O) circuitry and programming circuitry for selectively addressing the individual memory cells in accordance with the present invention. The cell access circuitry is represented in part by and includes one or more x-decoders and y-decoders, cooperating with I/O circuitry for connecting the source, gate, and drain of selected addressed memory cells to predetermined voltages or impedances to effect designated operations on the memory cell, e.g., programming, writing, reading, erasing, and deriving necessary voltages to effect such operations.

A timing diagram would have a vertical voltage axis and a horizontal time axis. A clock signal is cyclic and has two phases: Phase A and Phase B measured from about the middle of the rise and fall times such that the clock signal is going high to a digital one in the beginning of Phase A, low to a digital zero in the beginning of Phase B, and high to a digital one in the beginning of the next subsequent phase. A first wordline signal has a duration during which a wordline signal remains at a high voltage, or high, on a wordline for a read-only operation. A second wordline signal has a duration during which a wordline signal remains latched high on a wordline for a read-write operation to respectively read data in and write data to a memory cell.

A time delay exists because the wordline signals are triggered by the beginning of the clock signal but is delayed in reaching the wordlines because of decoding and other processes required before the wordline signals can be imposed on the wordlines. The various signals overlap at various times and voltages.

The present invention can be applied to read-modify write schemes where write operations are performed after read operations. In certain embodiments of the present invention, read and write operations can occur in a single clock cycle. Accordingly, read operations from the M x N cell array occur during both read-only operations and write operations.

For a read-only operation, the first wordline signal goes high ideally at the start of Phase A. The read operation is triggered by a falling clock edge of the clock signal. According to the present invention, the first wordline signal is shut down as soon as possible after the read operation to conserve power since power is being consumed whenever the wordline signal is being provided

If a write operation is desired, the second wordline signal goes high ideally at the start of Phase A and is extended throughout Phase B so that the write operation can occur within Phase B. However, the second wordline signal is unlatched and shut down as soon as possible after Phase B to conserve power.

A wordline latching memory circuit in accordance with the present invention has a clock connected to clock inputs of a set of address flip-flops. The set of address flip-flops include one or more address flip-flops for 1...n wordlines. In one embodiment, the address flip-flops are monotonic, or in continuous sequence, and each provide true and complementary outputs.

The set of address flip-flops is connected to a decoder, which causes the time delay. The decoder includes decoding circuits for decoding address information. Each of the decoding circuits includes a pair of NAND gates, which have outputs respectively coupled to an input of AND gates, which have respective outputs connected to an input of inverters. The outputs of the inverters are the outputs of the decoder.

The decoder can be of several types such as static decoders, dynamic decoders, or two-bit pre-decoders.

The decoder connects to latch circuitry. The latch circuitry includes a set of OAI gates, which are respectively connected to the inverters of the decoder. The number of OAI gates can vary depending on the specific application, but generally it is equal to the number of wordlines. For example, the OAI gates are respectively connected to wordlines. The decoder decodes the address information to select the wordlines, which will be activated when they have been selected.

Each of the OAI gates includes an OR gate and an AND gate. Each of the outputs from the inverters respectively connects to first inverting inputs of the OR gate, and each of the outputs of the AND gate respectively connects to second inverting inputs of the OR gates. The outputs of the OR gates are the respective output of the OAI gates to the wordlines. The outputs of the OR gate also respectively connect to first inputs of NAND gates. The NAND gates have respective outputs connected to first inverting inputs of the AND gate. Second inverting inputs of the AND gate are connected to the clock.

The clock also connects to a write-enable flip-flop, which responds to a write-enable signal and has an output that connects to second inputs of the NAND gates.

The wordlines are respectively connected to a set of memory cells having memory cells. The memory cells respectively include two pass transistors having gates to which the wordlines are respectively connected. The two pass transistors are respectively coupled to two inverters and to two bitlines. It will be understood that there will be a plurality of bitlines in the cell array.

The two bitlines are connected to sensing circuitry such as a sense-amp. The sense-amp is one of a plurality of sense-amps connected across the respective plurality of bitlines. The write-enable flip-flop connects to a first inverting input of a read-enable AND gate and the output of the read-enable AND gate connects to the sense-amp (and to other sense-amps for the other bitlines). A second inverting input of the read-enable AND gate is connectable to receive an enable signal.

A timing diagram would have a vertical voltage axis and a horizontal time axis for a read-only operation. The clock signal with the first wordline signal would indicate the duration in which a wordline signal remains high for the read-only operations. In accordance with the present invention, two bitline signals indicate signals on the bitlines. A vertical line would indicate an approximate trigger point of the sense-amp.

The first wordline signal rises shortly after the clock signal rises, due to the time delay. When the first wordline signal goes high, a differential builds. The bitline signal stays high all the time because it is connected to a high voltage side of the memory cell. The bitline signal slowly drops and is connected to the low voltage side of the memory cell; there is typically a 0 voltage at that point. Accordingly, there is a small voltage differential between the bitline signals indicative of a logical state of the memory cell. In order for the overall circuit to operate properly the differential must be amplified so that the signal goes from zero to high. The sense-amp amplifies the differential to provide a so-called full-swing voltage. The bitline signal lowers in voltage due to a capacitance on the transistor. The transistor has capacitance switch discharges causing the bitline signal to lower in voltage.

The bitline signal begins to rise again after the wordline signal goes low. As the wordline signal goes low, the bitline signal is not being pulled down. So the bitline signal gets charged back up. The bitline signal is charged back up because the bitline signal is always connected to a Vdd voltage source. A vertical line would indicate an approximate sense-amp trigger point of the sense-amp. This trigger point is important where the wordline latch circuit is a synchronous design, as it is in this specific embodiment. Because it is synchronous, events occur on the falling or rising edge of the clock cycle, subject to some delays; e.g., by the decoder delay.

During a write operation, the wordline goes low immediately after the write operation completes by using the falling edge of the clock signal to release the latch of the wordline signal. If the wordline goes low too soon, a write signal to the bitlineswill not be able to write to the memory cell because it will be shut off.

A timing diagram would have a vertical voltage axis and a horizontal time axis for a write operation. The clock signal and bitline signals would be involved. During the write operation in the Phase B, the memory cell is turned on; i.e., the pass transistors are turned on, connecting memory cell to the bitlines. The first wordline signal would have a duration in which the second wordline signal remains high for write operations.

The operation of wordline latching memory circuit is hereinafter described.

The address signals enter the address flip-flops timed by the clock signals from the clock. When the clock is asserted high, the set of address flip-flops is triggered creating a set of true and complimentary signals that are fed to the decoder. The address flip-flops selectively enable or disable the wordlines by providing selected signals to the groups of six inputs of the decoding circuits in the decoder.

The following is an example of the operation of the wordline latching memory circuit for a single wordline.

For a read-only operation, when the decoder determines the wordline has been selected, the NAND circuit outputs a low to the OAI gate. In the OAI gate, the inverting input of OR. gate is pulled low causing the output of OAI gate to rise as the first wordline signal rises.

The write-enable signal is held low so the output of the write-enable flip-flop is also forced low upon being triggered by the clock signal from the clock. This forces the output of NAND gate to be high, effectively disabling the AND gate and causing the OAI gate to provide a high on to the wordline. The high on the wordline activates the memory cell to place bitline signals, representative of previously stored high or lows signals, to be transferred onto the bitlines.

When the clock signal falls, the outputs of the address flip-flops are forced low to conserve power but the first wordline signal remains high because of the time delay.

The read operation is performed while the first wordline signal is high and after the clock signal reaches its low at the approximate sense-amp trigger point. The sense-amp is triggered by the clock signal and the enable signal via the read-enable AND gate to read the bitlines for the bitline signals. The sense-amp latches the data from the bitline signal from the bitline.

Shortly after the triggering of the sense-amp, the first wordline signal falls to its low.

For a read, the effective power cut-off to all the wordlines around the beginning of the falling edge of the clock signal conserves power and the read at around the end of the falling edge of the clock signal assures the security of the read operation.

The operation of the wordline latching memory circuit for the write operation is similar to that of the read operation. The main difference is that the wordline is being held high longer, but not so long that it interferes with the next clock cycle.

For a write operation, when the decoder determines the wordline has been selected, the NAND circuit outputs a low to the OAI gate. In the OAI gate, the inverting input of OR gate is pulled low causing the output of OAI gate to rise as the second wordline signal rises.

The write-enable signal is held high so the output of the write-enable flip-flop is also forced high upon being triggered by the clock signal from the clock. This forces the output of NAND gate to be low, enabling the AND gate and causing the OAI gate to provide a high on to the wordline. The high on the wordline activates the memory cell to place the bitline signals, representative of previously stored high or lows signals, onto the bitlines.

When the clock signal falls, the outputs of the address flip-flops are forced but the second wordline signal remains high even when the decoder provides a low to the OAI gate. With the write-enable flip-flop providing a high and the OAI gate providing a high, the NAND GATE provides a low to the first inverting input of the AND gate while the clock provides a second low to the second inverting input. As a result, the AND gate provides a high to the OR gate to latch the wordline in high.

The read operation can optionally be performed during Phase A.

The write operation is performed while the second wordline signal is still high in Phase B as indicated by the write pulse placed on the bitline by the bitline signal from the I/O circuitry.

The combination of the NAND gate and the OAI gate forms a latch which holds the wordline high until the clock signal starts rising again causing AND gate to unlatch the output of the OAI gate and de-assert the wordline.

For a write, the effective power cut-off to all the wordlines around the beginning of the rising edge of the clock signal assures the safety of the successful read operation in the next cycle.

Embodiments of the present invention can have several applications. In some applications the wordline latch circuit can be used in cache memory. Typically, cache memories are built of one or more smaller memory blocks called banks. The wordline latch circuit can be used inside the banks of cache memory. Other embodiments can be used outside of cache memory as well.

When used in a microprocessor for example, the microprocessor generates the memory addresses where the data resides. The microprocessor can have several layers of memory. There is a so-called Level 1 (L1) memory and a Level 2 (L2) memory, sometimes a Level 3 (L3) memory. There is also a main memory. The main memory is also called external memory because it is typically external to the microprocessor. L1 memory is the easiest and fastest memory to access. When the microprocessor looks for data it will typically start with L1 memory, then will go to L2 memory, then L3 memory, and finally to the main memory.

If the microprocessor fetches data from the main memory it could take about 100 - 150 clock cycles to fetch. This is slow compared to 1 to 2 clock cycles that would be required to fetch data from the cache memory. Thus there are compelling reasons to have data stored on the chip itself.

While the invention has been described in conjunction with a specific best mode, it is to be understood that many alternatives, modifications, and variations will be apparent to those skilled in the art in light of the aforegoing description. Accordingly, it is intended to embrace all such alternatives, modifications, and variations which fall within the scope of the included claims. All matters hither-to-fore set forth herein or shown in the accompanying drawings are to be interpreted in an illustrative and non-limiting sense.

## Claims

1. A method for memory system operation comprising:
providing memory cells for containing data;
writing data in and reading data from the memory cells on bitlines;
responding to wordline signals on wordlines by causing the bitlines to write data in the memory cells;
selecting a wordline for a write to a memory cell using a decoder for receiving and decoding address information in response to a clock signal and an address signal;
latching a wordline signal in response to the clock signal by providing the wordline signal to the selected wordline for the write to the memory cell and for unlatching the wordline signal from the selected wordline when the write to the memory cell is complete, **characterised in that** selecting the wordline includes responding to a rising edge of the clock signal by the decoder to start decoding and a falling edge of the clock signal to stop decoding; and latching a wordline signal includes:
responding to the falling edge of the clock signal and a write-enable signal by latching the wordline signal on the selected wordline for writing to the memory cell; and responding to a second rising edge of the clock signal by unlatching the wordline signal from the selected wordline.

2. The method for memory system operation as claimed in claim 1 including:
providing the wordline signal to the selected wordline for reading of the memory cell and removing the wordline signal from the selected wordline when the reading of the memory cell is complete.

3. The method for memory system operation as claimed in claim 1 or 2 wherein:
selecting the wordline includes responding to the clock signal having a rising and falling edges to start decoding on the rising edge and to stop decoding on the falling edge; and
including:
responding to the falling edge and a read-enable signal for reading data from the memory cells by sensor circuitry.

4. The method for memory system operation as claimed in any of claims 1, 2 or 3 including:
providing the clock signal having rising and falling edges including:
responding to the middle of the rising edge to start decoding and the middle of the falling edge to stop decoding by the decoder; and
responding to the middle of the falling edge and a write-enable signal for latching the wordline signal on the selected wordline for the writing to the memory cell and responding to the middle of the second rising edge for unlatching the wordline signal from the selected wordline.

5. A memory system comprising:
memory cells for containing data;
bitlines for writing data in and reading data from the memory cells;
wordlines for causing the bitlines to write data in the memory cells in response to wordline signals;
a decoder to receive and decode address information in response to a clock signal and an address signal to select a wordline for a write to a memory cell;
a latch circuitry responsive to the clock signal to provide the wordline signal to the selected wordline for the write to the memory cell and to remove the wordline signal from the selected wordline when the write to the memory cell is complete, **characterised in that** the decoder is responsive to the clock signal having rising and falling edges, and the decoder is responsive to the rising edge to start to the decode and the falling edge to stop the decode; and the latch circuitry is responsive to the falling edge of the clock signal and a write-enable signal to latch the wordline signal on the selected wordline for the write to the memory cell, and the latch circuitry is responsive to a second rising edge of the clock signal to unlatch the wordline signal from the selected wordline .

6. The memory system as claimed in claim 5 wherein:
the latch circuitry includes circuitry to provide the wordline signal to the selected wordline for a read of the memory cell and to remove the wordline signal from the selected wordline when the read of the memory cell is complete.

7. The memory system as claimed in claim 5 or 6 including:
sensor circuitry connected to the bitlines and responsive to the falling edge and a read-enable signal to read data from the memory cells.

8. The memory system as claimed in any of claims 5, 6 or 7 including:
a clock providing the clock signal, the clock signal having rising and falling edges wherein:
the decoder is responsive to the onset of the rising edge to start the decode and the onset of the falling edge to stop the decode; and
the latch circuitry is responsive to the middle of the falling edge and a write-enable signal to latch the wordline signal on the selected wordline for the write to the memory cell, the latch circuitry responsive to the middle of the second rising edge to unlatch the wordline signal from the selected wordline.

## Patentansprüche

1. Verfahren für den Betrieb eines Speichersystems mit:
Bereitstellen von Speicherzellen zur Aufbewahrung von Daten;
Schreiben von Daten in die Speicherzellen und Auslesen der Daten aus den Speicherzellen über Bitleitungen;
Reagieren auf Wortleitungssignale, die in Wortleitungen übertragen werden, durch Veranlassen, dass die Bitleitungen Daten in Speicherzellen schreiben;
Auswählen einer Wortleitung für einen Schreibvorgang in eine Speicherzelle, unter Anwendung eines Decodierers, der zum Empfangen und Decodieren von Adresseninformationen ausgebildet ist, in Reaktion auf ein Taktsignal und ein Adressensignal;
Zwischenspeichern eines Wortleitungssignals in Reaktion auf das Taktsignal durch Zuführen des Wortleitungssignals zu der ausgewählten Wortleitung für den Schreibvorgang für die Speicherzelle und nicht mehr Speichern des Wortleitungssignals von der ausgewählten Wortleitung, wenn der Schreibvorgang in die Speicherzelle abgeschlossen ist, **dadurch gekennzeichnet, dass**
Auswählen der Wortleitung das Reagieren auf eine ansteigende Flanke des Taktsignals durch den Decodierer zum Beginnen des Decodierens und das Reagieren auf eine abfallende Flanke des Taktsignals zum Stoppen des Decodierens umfasst; und Zwischenspeichern eines Wortleitungssignals umfasst:
Reagieren auf die abfallende Flanke des Taktsignals und auf ein Schreibaktivierungssignal durch Zwischenspeichern des Wortleitungssignals aus der ausgewählten Wortleitung zum Schreiben in die Speicherzelle; und
Reagieren auf eine zweite ansteigende Flanke des Taktsignals durch nicht mehr Speichern des Wortleitungssignals von der ausgewählten Wortleitung.

2. Verfahren zum Betreiben eines Speichersystem in Anspruch 1, mit:
Bereitstellen des Wortleitungssignals für die ausgewählte Wortleitung zum Auslesen der Speicherzelle und Abkoppeln des Wortleitungssignals von der ausgewählten Wortleitung, wenn das Auslesen der Speicherzelle abgeschlossen ist.

3. Verfahren zum Betreiben eines Speichersystems nach Anspruch 1 oder 2, wobei:
Auswählen der Wortleitung umfasst: Reagieren auf das Taktsignal, das eine ansteigende und eine abfallende Flanke aufweist, um das Decodieren bei der ansteigenden Flanke zu beginnen und das Decodieren bei der abfallenden Flanke zu beenden; und
mit:
Reagieren auf die abfallende Flanke und ein Leseaktivierungssignal zum Auslesen von Daten aus den Speicherzellen durch eine Fühlerschaltung.

4. Verfahren zum Betreiben des Speichersystems nach einem der Ansprüche 1, 2 oder 3 mit:
Bereitstellen des Taktsignals mit der ansteigenden und der abfallenden Flanke:
Reagieren auf den mittleren Bereich der ansteigenden Flanke, um das Decodieren zu beginnen, und Reagieren auf den mittleren Bereich der abfallenden Flanke, um das Decodieren mittels des Decodierers zu beenden; und
Reagieren auf den mittleren Bereich der abfallenden Flanke und ein Schreibaktivierungssignal, um das Wortleitungssignal auf der ausgewählten Wortleitung zum Schreiben in die Speicherzelle zwischen zu speichern, und Reagieren auf den mittleren Bereich der zweiten ansteigenden Flanke, um das Wortleitungssignal von der ausgewählten Wortleitung nicht mehr zu speichern.

5. Speichersystem mit:
Speicherzellen zum Bewahren von Daten;
Bitleitungen zum Schreiben von Daten in die Speicherzellen und zum Auslesen von Daten daraus;
Wortleitungen, um die Bitleitungen zu veranlassen, Daten in die Speicherzellen in Reaktion auf Wortleitungssignale zu schreiben;
einem Decodierer zum Empfangen von Decodieradresseninformation in Reaktion auf ein Taktsignal und ein Adressensignal, um eine Wortleitung für einen Schreibvorgang in eine Speicherzelle auszuwählen;
einer Zwischenspeicherschaltung, die auf das Taktsignal reagiert, um das Wortleitungssignal zu der ausgewählten Wortleitung für den Schreibvorgang in die Speicherzelle zuzuführen und das Wortleitungssignal von der ausgewählten Wortleitung abzukoppeln, wenn der Schreibvorgang in die Speicherzelle abgeschlossen ist, **dadurch gekennzeichnet, dass**
der Decodierer ausgebildet ist, auf das Taktsignal mit der ansteigenden und der abfallenden Flanke zu reagieren, und ferner ausgebildet ist, auf die ansteigende Flanke zum Beginnen des Decodierens und auf die abfallende Flanke zum Beenden des Decodierens zu reagieren; und
die Zwischenspeicherschaltung ausgebildet ist, auf die abfallende Flanke des Taktsignals und ein Schreibfreigabesignal zu reagieren, um das Wortleitungssignal auf der ausgewählten Wortleitung für den Schreibvorgang in die Speicherzelle zu speichern, und wobei die Zwischenspeicherschaltung ferner ausgebildet ist, auf eine zweite ansteigende Flanke des Taktsignals zu reagieren, um das Wortleitungssignal von der ausgewählten Wortleitung in dem Zwischenspeicher zu mehr zu speichern.

6. Speichersystem nach Anspruch 5, wobei:
die Zwischenspeicherschaltung eine Schaltung aufweist, um das Wortleitungssignal der ausgewählten Wortleitung für einen Lesevorgang der Speicherzelle zuzuführen und das Wortleitungssignal aus der ausgewählten Wortleitung abzukoppeln wenn der Lesevorgang der Speicherzelle abgeschlossen ist.

7. Speichersystem nach Anspruch 5 oder 6 mit:
einer Fühlerschaltung, die mit den Bitleitungen verbunden ist und auf die abfallende Flanke und ein Leseaktivierungssignal reagiert, um Daten aus den Speicherzellen auszulesen.

8. Speichersystem nach einem der Anspruche 5, 6 oder 7 mit:
einem Zeitgeber zur Bereitstellung des Taktsignals, wobei das Taktsignal eine ansteigende und eine abfallende Flanke aufweist, wobei:
der Decodierer auf den Beginn der ansteigenden Flanke reagiert, um das Decodieren zu beginnen, und auf den Beginn der abfallenden Flanke reagiert, um das Decodieren zu beenden; und
die Zwischenspeicherschaltung ausgebildet ist, auf den mittleren Bereich der abfallenden Flanke und ein Schreibaktivierungssignal zu reagieren, um das Wortleitungssignal auf der ausgewählten Wortleitung für den Schreibvorgang in die Speicherzelle zu speichern, und wobei die Zwischenspeicherschaltung ausgebildet ist, auf den mittleren Bereich der zweiten ansteigenden Flanke zu reagieren, um das Wortleitungssignal von der ausgewählten Wortleitung in dem Zwischenspeicher nicht mehr zu speichern.

## Revendications

1. Procédé destiné à un fonctionnement de système de mémoire comprenant les étapes consistant à :
prévoir des éléments de mémoire pour contenir des données ;
écrire des données dans, et lire des données à partir, des éléments de mémoire sur des lignes de binaires ;
répondre aux signaux de lignes de mot sur des lignes de mots en entraînant les lignes de binaires à écrire des données dans les éléments de mémoire ;
sélectionner une ligne de mot pour une écriture dans un élément de mémoire en utilisant un décodeur pour recevoir et décoder une information d'adresse en réponse à un signal d'horloge et à un signal d'adresse ;
verrouiller un signal de ligne de mot en réponse au signal d'horloge en fournissant le signal de ligne de mot à la ligne de mot sélectionnée correspondant à l'écriture dans l'élément de mémoire et pour déverrouiller le signal de ligne de mot à partir de la ligne de mot sélectionnée lorsque l'écriture dans l'élément de mémoire est achevée, **caractérisé en ce que** sélectionner la ligne de mot inclut de
répondre à un front montant du signal d'horloge par le décodeur pour amorcer un décodage et à un front descendant du signal d'horloge pour arrêter le décodage ; et verrouiller un signal de ligne de mot inclut de :
répondre au front descendant du signal d'horloge et à un signal de validation d'écriture en verrouillant le signal de ligne de mot sur la ligne de mot sélectionnée en vue d'une écriture dans l'élément de mémoire ;
et répondre à un second front montant du signal d'horloge en déverrouillant le signal de ligne de mot à partir de la ligne de mot sélectionnée.

2. Procédé destiné à un fonctionnement de système de mémoire selon la revendication 1, incluant de
fournir le signal de ligne de mot à la ligne de mot sélectionnée pour une lecture de l'élément de mémoire et éliminer le signal de ligne de mot de la ligne de mot sélectionnée lorsque la lecture de l'élément de mémoire est achevée.

3. Procédé destiné à un fonctionnement de système de mémoire selon la revendication 1 ou 2, dans lequel :
sélectionner la ligne de mot inclut de répondre au signal d'horloge comportant des fronts montant et descendant pour commencer un décodage sur le front montant et arrêter un décodage sur le front descendant; et incluant de :
répondre au front descendant et à un signal de validation de lecture pour lire des données à partir des éléments de mémoire par l'intermédiaire d'un circuit détecteur.

4. Procédé destiné à un fonctionnement de système de mémoire selon l'une quelconque des revendications 1, 2 ou 3, incluant de :
fournir le signal d'horloge comprenant des fronts montant et descendant incluant de :
répondre au milieu du front montant pour amorcer un décodage et au milieu du front descendant pour arrêter un décodage par le décodeur ; et
répondre au milieu du front descendant et à un signal de validation d'écriture pour verrouiller le signal de ligne de mot sur la ligne de mot sélectionnée pour l'écriture dans l'élément de mémoire et répondre au milieu du second front montant pour déverrouiller le signal de ligne de mot à partir de la ligne de mot sélectionnée.

5. Système de mémoire comportant :
des éléments de mémoire pour contenir des données ;
des lignes de binaires pour écrire des données dans, et lire des données à partir, des éléments de mémoire, en réponse à des signaux de ligne de mot ;
des lignes de mot pour entraîner les lignes de binaires à écrire des données dans les éléments de mémoire en réponse aux signaux de ligne de mot ;
un décodeur pour recevoir et décoder une information d'adresse en réponse à un signal d'horloge et un signal d'adresse pour sélectionner une ligne de mot en vue d'une écriture dans un élément de mémoire ;
un circuit de verrouillage répondant au signal d'horloge pour fournir le signal de ligne de mot à la ligne de mot sélectionnée en vue de l'écriture dans l'élément de mémoire et pour éliminer le signal de ligne de mot de la ligne de mot sélectionnée lorsque l'écriture dans l'élément de mémoire est achevée, **caractérisé en ce que** le décodeur répond au signal d'horloge présentant des fronts montant et descendant, et **en ce que** le décodeur répond au front montant pour amorcer le décodage et au front descendant pour arrêter le décodage ; et **en ce que**
le circuit de verrouillage répond au front descendant du signal d'horloge et à un signal de validation d'écriture pour verrouiller le signal de ligne de mot sur la ligne de mot sélectionnée pour l'écriture dans l'élément de mémoire, et **en ce que** le circuit de verrouillage répond à un second front montant du signal d'horloge pour déverrouiller le signal de ligne de mot à partir de la ligne de mot sélectionnée.

6. Système de mémoire selon la revendication 5, dans lequel :
le circuit de verrouillage comporte un circuit pour fournir le signal de ligne de mot à la ligne de mot sélectionnée pour une lecture d'un élément de mémoire et pour éliminer le signal de ligne de mots de la ligne de mot sélectionnée lorsque la lecture de l'élément de mémoire est achevée.

7. Système de mémoire selon la revendication 5 ou 6 comportant :
un circuit détecteur connecté aux lignes de binaires et répondant au front descendant et à un signal de validation de lecture pour lire des données à partir des éléments de mémoire.

8. Système de mémoire selon l'une quelconque des revendications 5, 6 ou 7, comportant :
une horloge fournissant le signal d'horloge, le signal d'horloge présentant des fronts montant et descendant ;
le décodeur répondant à l'établissement du front montant pour amorcer le décodage et à l'établissement du front descendant pour arrêter le décodage ; et
le circuit de verrouillage répondant à la moitié du front montant et à un signal de validation d'écriture pour verrouiller le signal de ligne de mot sur la ligne de mot sélectionnée en vue de l'écriture dans l'élément de mémoire , le circuit de verrouillage répondant à la moitié du second front montant pour déverrouiller le signal de ligne de mot à partir de la ligne de mot sélectionnée.
